# EUROPÄISCHE PATENTSCHRIFT

(11) **EP 1 176 856 B1**
(45) Veröffentlichungstag und Bekanntmachung des Hinweises auf die Patenterteilung: **23.09.2009**
(21) Anmeldenummer: 01000316.8
(22) Anmeldetag: 24.07.2001
(51) Int. Cl.: H05G 1/06, H05K 7/20

(54) **Hochspannungserzeuger mit Hybridisolierung**
High-voltage generator with hybrid insulation
Genérateur haute tension avec isolation hybride

(30) Priorität: 26.07.2000 DE 10036301
(43) Veröffentlichungstag der Anmeldung: 30.01.2002
(73) Patentinhaber: Philips Intellectual Property & Standards GmbH, 20099 Hamburg (DE); Koninklijke Philips Electronics N.V., 5621 BA Eindhoven (NL)
(72) Erfinder: Negle, Hans, c/o Philips Corp. Int. Prop. GmbH, 52064 Aachen (DE)

(56) Entgegenhaltungen:
- US-A- 4 767 961
- US-A- 5 222 118
- US-A- 5 384 821
- US-A- 5 676 198

## Beschreibung

Die Erfindung betrifft einen Hochspannungserzeuger mit einer Hybridisolierung, insbesondere für rotierende Röntgensysteme mit hoher Rotationsgeschwindigkeit und auch solche Systeme, bei denen der Hochspannungserzeuger mit einem Röntgensystem zu einer Einheit ("Eintankgenerator") integriert ist.

Röntgensysteme umfassen im allgemeinen einen Röntgenstrahler mit einer Röntgenröhre zur Erzeugung von Röntgenstrahlen, sowie einen Hochspannungserzeuger, der die zum Betrieb der Röntgenröhre erforderliche Hochspannung zur Verfügung stellt.

Bei rotierenden Röntgensystemen, wie sie zum Beispiel in Computertomographie-Geräten (CT-Gerät) verwendet werden, ist ein geringes Gewicht von besonderer Bedeutung. Dies betrifft insbesondere solche Systeme, die mit einer Rotationsgeschwindigkeit von mehreren Umdrehungen pro Sekunde arbeiten, wie zum Beispiel Subsekundenscanner, bei denen Zentrifugalkräfte von 30 G oder mehr auftreten können.

Aus der JP-A-06 111 991 ist ein Röntgensystem mit einer Hybridisolierung bekannt, die durch ein Isolieröl für die Röntgenröhre und ein isolierendes Gas unter hohem Druck für den Hochspannungserzeuger gebildet ist. Durch Verwendung des Gases als Isoliermittel für den Hochspannungserzeuger soll die Menge des Öls und damit das Gewicht vermindert werden. Ein Nachteil dieses Systems besteht jedoch darin, dass ein entsprechender Druckbehälter erforderlich ist, der erhebliche Zusatzkosten verursachen kann, und dass die thermische und damit auch die elektrische Belastbarkeit relativ gering ist, da das Gas im Vergleich zu einem Öl in nur sehr begrenztem Umfang die entstehende Wärme abführen kann.

Eine Aufgabe, die der Erfindung zugrunde liegt, besteht deshalb darin, einen Hochspannungserzeuger zu schaffen, der bei geringem Gewicht eine wesentlich höhere elektrische Ausgangsleistung erzeugen kann.
Gelöst wird diese Aufgabe mit einem Hochspannungserzeuger mit einer Hybridisolierung, die mindestens einen Isolierkörper aufweist, der so geformt und angeordnet ist, dass eine Mehrzahl von miteinander verbundenen Strömungskanälen für ein Isolier-Fluid entsteht, deren Querschnitte so bemessen sind, dass im Betriebszustand in Bereichen mit hoher Feldstärke und /oder hoher Wärmeentwicklung eine im Vergleich zu anderen Bereichen höhere Strömungsgeschwindigkeit erzielbar ist.

Ein besonderer Vorteil dieser Lösung besteht darin, dass durch die Schaffung von Strömungskanälen die Wärmeabführung, d.h. die thermische Wirksamkeit des strömungsfähigen Isoliermittels (in thermisch besonders hoch belasteten Bereichen) wesentlich höher ist.

Außerdem wird die Spannungsfestigkeit (in Bereichen mit besonders hoher Feldstärke) dadurch erhöht, dass einerseits durch die höhere Strömungsgeschwindigkeit und die Ausgestaltung der Kanäle die Wahrscheinlichkeit der Ausbildung von Faserbrücken, die eine häufige Ursache für Spannungsüberschläge darstellen, wesentlich vermindert wird, und andererseits der direkte Verbindungsweg der auf Hochspannung befindlichen Komponenten zum Erdpotential durch die Isolierkörper unterbrochen wird.

Alles dies führt dazu, dass die Leistungsdichte, d.h. das Verhältnis zwischen der (maximalen) Ausgangsleistung und der Größe bzw. dem Gewicht des Hochspannungserzeugers wesentlich gesteigert werden kann.

In der US-PS 5,497,409 wird zwar eine "radiogene Einheit" aus einer einpoligen Röntgenröhre und anderen Komponenten beschrieben, die in bestimmter Weise angeordnet und teilweise von einem flüssigen Kühlmittel sowie einem Kunststoff umgeben sind. Damit soll im Zusammenwirken mit weiteren Maßnahmen die Kühlung verbessert werden. Allerdings spielt hierbei das Gewicht der Einheit im Verhältnis zur Ausgangsleistung und der Spannungsfestigkeit keine Rolle, und es wird auch kein Gebrauch von unterschiedlichen Strömungsgeschwindigkeiten insbesondere im Bereich der Hochspannungskomponenten des Hochspannungserzeugers gemacht.

Die Unteransprüche haben vorteilhafte Weiterbildungen der Erfindung zum Inhalt.

In einem Ausführungsbeispiel ist der mindestens eine Isolierkörper so geformt und angeordnet, dass das Isolier-Fluid durch Konvektion und /oder Eigenbewegung aufgrund einer Einwirkung eines durch den Hochspannungserzeuger im Betriebszustand erzeugten Feldes durch die Strömungskanäle strömt. Die Strömungserzeugung gemäß diesem Ausführugsbeispiel bietet sich insbesondere für eine Ausführung mit relativ geringer Ausgangsleistung an und hat den Vorteil, dass keine Zusatzeinrichtungen wie zum Beispiel Pumpen erforderlich sind

Besonders vorteilhaft ist die Ausführungsform gemäß Anspruch 3, da einerseits die positiven Eigenschaften einer Isolierflüssigkeit, wie zum Beispiel hohe thermische Leitfähigkeit im Strömungsfall, hohe Spannungsfestigkeit sowie Selbstheilung im Falle eines Spannungsüberschlags genutzt werden können, andererseits aber der wesentliche Nachteil, der in dem im allgemeinen relativ hohen Gewicht liegt, nur in sehr geringem Masse in Kauf genommen werden muss, da die Menge der Isolierflüssigkeit aufgrund seiner durch die Strömung erhöhten Wirksamkeit wesentlich stärker reduziert werden kann.

Die Ausführungsform gemäß Anspruch 4 hat die Vorteile, dass einerseits die Oberfläche eines solchen Hartschaums sehr glatt ist, so dass die Strömung des Isolier-Fluids kaum gehemmt wird, und andererseits durch die Mikroporosität eine sehr hohe Spannungsfestigkeit erzielt werden kann.

Auch die Ausführungsform gemäß Anspruch 5 führt zu einer weiteren Erhöhung der Spannungsfestigkeit des Gesamtsystems, da die elektrischen Feldlinien beim Übergang zwischen dem Isolierkörper und dem Isolier-Fluid nicht nennenswert gebrochen werden und folglich die damit verbundenen negativen Oberflächeneffekte wie die Ausbildung von Raumladungen sowie von Tangentialkomponenten der Feldstärke entlang der Übergangsfläche nicht auftreten.

Die Ausführungsform gemäß Anspruch 6 ist insbesondere dann vorteilhaft, wenn es in erster Linie auf ein möglichst geringes Gewicht des Hochspannungserzeugers ankommt.

Mit den Ausführungsformen gemäß den Ansprüchen 7 bis 10 ist die Wärmeabführung besonders hoch, so dass relativ hohe Ausgangsleistungen erzeugt werden können.
Der erfindungsgmäße Hochspannungserzeuger lässt sich schließlich mit nahezu jedem Röntgenstrahler zu einem Röntgensystem kombinieren, da seine Dauerleistung durch entsprechende Auslegung gemäß obiger Beschreibung in weiten Grenzen skalierbar ist. Dies betrifft auch die Anwendung in einem Computertomographie-Gerät, für die der Hochspannungserzeuger mit besonders geringem Gewichte dimensioniert werden kann.

Weitere Einzelheiten, Merkmale und Vorteile der Erfindung ergeben sich aus der folgenden Beschreibung einer bevorzugten Ausführungsform anhand der Zeichnung. Es zeigt:

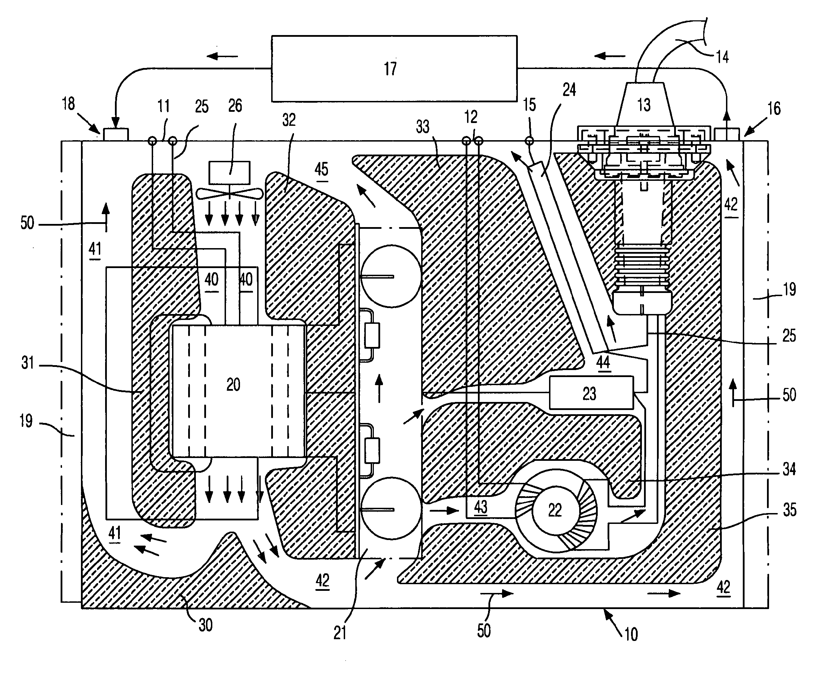

Fig. 1 schematisch einen Querschnitt durch eine solche Ausführungsform.

Der erfindungsgemäße Hochspannungserzeuger umfasst ein Gehäuse 10 mit einem ersten Eingangsanschluss 11 für eine in die Hochspannung umzusetzende erste Eingangsspannung, einem zweiten Einganganschluss 12 für eine in eine Heizspannung umzusetzende zweite Eingangsspannung, einem ersten Ausgangsanschluss 13 zur Verbindung mit einer Röntgenröhre über ein Hochspannungskabel 14, einem zweiten Ausgangsanschluss 15, an dem eine Messspannung anliegt, einem Auslass 16 für ein Isolier-Fluid 50, das über einen Wärmetauscher 17 geführt und über einen Einlass 18 wieder in das Gehäuse 10 eingeleitet wird. Das Gehäuse 10 weist an seinen Außenwänden Kühlrippen 19 oder gesonderte Kühlkörper auf.

In dem Gehäuse 10 befinden sich die wesentlichen elektrischen Komponenten des Hochspannungserzeugers, nämlich ein Transformator 20, ggf. eine Spannungskaskade 21, ein Heiztransformator 22, ein Dämpfungswiderstand 23 sowie ein Messteiler 24, die über verschiedene Leitungen 25 mit den Eingangsanschlüsaen 11,12, dem Ausgangsanschluss 13 sowie untereinander in bekannter Weise verbunden sind.

Mit dem Transformator 20 und der Spannungskaske 21 wird die an dem ersten Eingangsanschluss 11 anliegende erste Eingangsspannung in eine Hochspannung umgewandelt und über den Dämpfungswiderstand 23 an den Ausgangsanschluss 13 geführt. Weiterhin wird die an dem zweiten Eingangsanschluss 12 anliegende zweite Eingangsspannung mit dem Heiztransformator 22 in eine für eine Kathode der Röntgenröhre geeignete Heizspannung umgesetzt und ebenfalls zu dem Ausgangsanschluss 13 geführt. Die Funktionen und die Dimensionierung eines solchen Hochspannungserzeugers sind allgemein bekannt und sollen deshalb nicht weiter beschrieben werden.

Erfindungsgemäß befinden sich in dem Gehäuse 10 eine Mehrzahl von Isolierkörpern 30, 31, 32, 33, 34 und 35, die so angeordnet und geformt sind, dass Kanäle 40, 41, 42, 43, 44 und 45 entstehen.

Ein Teil dieser Kanäle, nämlich die Kanäle 40, 43, 44 und 45 sind zuführende Kanäle und führen in solche Bereiche des Hochspannungserzeugers, in denen im Betriebszustand eine hohe Wärmeentwicklung entsteht und /oder eine hohe elektrische Feldstärke erzeugt wird. Dies sind in erster Linie die Bereiche, in denen sich der Transformator 20 und die Spannungskaskade 21 befindet, und in zweiter Linie der Heiztransformator 22, der Dämpfungswiderstand 23 sowie der Messteiler 24.

Die beiden anderen Kanäle 41,42 stellen rückführende Kanäle dar, die mit einem wesentlichen Teil ihrer Länge entlang der mit den Kühlkörpern 19 versehenen Außenwände des Gehäuses 10 geführt sind.

Die Kanäle sind so miteinander verbunden, dass mehrere geschlossene Kreisläufe entstehen, in denen das Isolier-Fluid 50, bei dem es sich vorzugsweise um eine hochspannungsgeeignete Isolierflüssigkeit, wie zum Beispiel ein Isolieröl, Silikon oder eine Esterflüssigkeit handelt, zirkulieren kann. Die Kanäle sind außerdem so geführt, dass die Zirkulation in erster Linie durch Konvektion, das heißt durch Aufnahme von Wärme in den Bereichen mit hoher Wärmeentwicklung und durch Abgabe von Wärme an den Außenwänden und über die Kühlkörper 19 des Gehäuses in Gang gesetzt wird. Die Zirkulation kann in zweiter Linie außerdem durch die Eigenbewegung des Isolier-Fluids aufgrund einer Einwirkung hoher Feldstärken, wie sie zum Beispiel an der Spannungskaskade 21 entstehen, ausgelöst oder zumindest unterstützt werden.

Zur Erhöhung der Wirksamkeit dieser Strömungen sind die Querschnitte der rückführenden Kanäle 41, 42 vorzugsweise größer, als die Querschnitte der zuführenden Kanäle 40, 43, 44 und 45. Dies hat zur Folge, dass die Strömungsgeschwindigkeit in den zuführenden Kanälen größer ist, so dass einerseits die Wärme schneller abgeführt und andererseits die Wahrscheinlichkeit der Ausbildung von Faserbrücken (entlang denen bevorzugt Spannungsüberschläge auftreten) vermindert wird, so dass sowohl die thermische, als auch die elektrische Festigkeit dieser Bereiche erhöht wird. Die demgegenüber größeren Querschnitte der rückführenden Kanäle, die so gelegt sind, dass eine möglichst große Berührungsfläche mit der Außenwand des Gehäuses entsteht, bewirken eine geringere Strömungsgeschwindigkeit und eine gute Wärmeabgabe aus dem Isoliermittel nach außerhalb des Gehäuses.

Außerdem können natürlich auch die Querschnitte der zuführenden Kanäle 40, 43, 44 und 45 an sich unterschiedlich sein. In Bereichen mit hoher Feldstärke und /oder hoher Wärmeentwicklung, das heißt insbesondere an dem Transformator 20, dem Heiztransformator 22, dem Dämpfungswiderstand 23 sowie dem Messteiler 24 ist ein im Vergleich zu den anderen Bereichen geringerer Querschnitt und damit eine höhere Strömungsgeschwindigkeit sinnvoll.

Diese Strömungszustände sind für einen ersten, relativ niedrigen Leistungsbereich des Hochspannungserzeugers im allgemeinen ausreichend, um einen sicheren Betrieb zu gewährleisten. Dieser erste Leistungsbereich erstreckt sich zum Beispiel bis etwa 1 kW Dauerleistung. Für einen zweiten, mittleren Leistungsbereich mit einer Dauerleistung von bis zu etwa 2 kW ist zur Erhöhung der Strömungsgeschwindigkeit in den Kanälen eine erste Fördereinrichtung 26 in dem Gehäuse 10 vorgesehen, die zum Beispiel durch eine einfache Pumpe realisiert werden kann. Für einen dritten, hohen Leistungsbereich wird das Isolier-Fluid 50 über den Auslass 16 durch den Wärmetauscher 17 und den Einlass 18 wieder zurück in den Strömungskreislauf geführt. Dieser Wärmetauscher 17 kann zusätzlich eine zweite Fördereinrichtung (Pumpe) beinhalten, mit der das Isolier-Fluid durch diesen hindurch gepumpt wird. Durch bedarfsgerechtes Schalten dieser zweiten Fördereinrichtung sowie gegebenenfalls der ersten Fördereinrichtung 26 können in dem hohen Leistungsbereich mehrere Leistungsstufen eingestellt werden, die zum Beispiel bei etwa 3,5 kW, 7 kW und 15 kW liegen können.

Die Isolierkörper 30, 31, 32, 33, 34 und 35 sind aus einem mikroporösen Hartschaum hergestellt. Dieser Hartschaum beinhaltet eine große Anzahl von durch eine Polymerhülle gebildeten Mikrokugeln (Bläschen), die ein Gas einschließen. Im Ausgangszustand haben diese Kugeln einen Durchmesser von etwa 10 µm. Durch Erwärmen des Hartschaums dehnen sich die Kugeln in Abhängigkeit von der Temperatur auf einen Durchmesser von bis zu 40 µm aus. Da die Spannungs-Durchschlagsfestigkeit eines solchen Hartschaums wesentlich durch den Durchmesser der Kugeln bestimmt wird, wird der Hartschaum nur so stark erwärmt, dass sich ein optimaler Wert für die Spannungsfestigkeit sowie die gewünschte Dielektrizitätskonstante ergibt.

Die Dielektrizitätskonstante sollte im wesentlichen derjenigen des Isolier-Fluids entsprechen, damit die elektrischen Feldlinien beim Übergang zwischen dem Hartschaum und dem Isolier-Fluid nicht nennenswert gebrochen werden und keine negativen Oberflächeneffekte wie die Ausbildung von Raumladungen sowie von Tangentialkomponenten der Feldstärke entlang der Übergangsfläche auftreten. Damit wird eine weitere Erhöhung der Spannungsfestigkeit des Gesamtsystems erzielt.

Die Anpassung der Dielektrizitätskonstante kann durch entsprechende Wahl des Gasgehalts und der Gaszusammensetzung in den Kugeln in bekannter Weise vorgenommen werden.

Der Hartschaum ist vorzugsweise geschlossenzellig ausgebildet, so dass eine besonders glatte Oberfläche entsteht, entlang der das Isolier-Fluid ohne großen Widerstand und ohne in den Hartschaum einzudringen, fließen kann.

Um im Falle der (im allgemeinen bevorzugten) Anwendung von Öl als Isolier-Fluid die Menge des erforderlichen Öls und damit das Gesamtgewicht des Hochspannungserzeugers so gering wie möglich zu halten, füllen die Isolierkörper 30, 31, 32, 33, 34 und 35 soweit wie möglich alle Bereiche mit relativ niedriger Wärmeentwicklung und niedriger Feldstärke aus. Nur dort, wo durch einen Isolierkörper allein eine für einen sicheren Betrieb ausreichende Wärmeabführung oder eine ausreichende Spannungsfestigkeit nicht mehr zu erzielen ist, verlaufen die Kanäle für das Isoliermittel.
Mit dieser Ausführungsform ist es möglich, einen sehr kompakten und mit einer sehr hohen Dauerleistung betreibbaren Hochspannungserzeuger zu realisieren, der eine hohe Ausgangsleistung bei vergleichsweise geringem Volumen und Gewicht aufweist.

Durch die gezielte Wärmeabführung aus Bereichen mit hoher elektrischer und thermische Belastung ist es weiterhin möglich, den Hochspannungserzeuger mit einheitlichen elektrischen Komponenten auszustatten und die abzugebende Leistung - und damit verbunden auch die auftretende Verlustleistung - für völlig unterschiedliche Applikationen auszulegen. Diese erstrecken sich von der einfachen Radiographie mit wenigen 100 W Dauerleistung über Cardio /Vascular-Anwendungen mit Dauerleistungen zwischen 2 und 5 kW, bis hin zu Highclass-Computertomographie-Geräten mit bis zu 15 kW Dauerleistung und hohen Rotationsgeschwindigkeiten.

Darüber hinaus ist das erfindungsgemäße Prinzip der Hybridisolierung natürlich auch auf andere Hochspannungsanlagen, wie zum Beispiel in Umspannwerken anwendbar.

## Patentansprüche

1. Hochspannungserzeuger mit einer Hybridisolierung,
**dadurch gekennzeichnet,**
**dass** die Hybridisolierung mindestens einen Isolierkörper (30 bis 35) aufweist, der so geformt und angeordnet ist, dass eine Mehrzahl von miteinander verbundenen Strömungskanälen (40 bis 45) für ein Isolier-Fluid (50) entsteht, deren Querschnitte so bemessen sind, dass im Betriebszustand in Bereichen mit hoher Feldstärke eine im Vergleich zu anderen Bereichen höhere Strömungsgeschwindigkeit erzielbar ist.

2. Hochspannungserzeuger nach Anspruch 1,
wobei die Querschnitte so bemessen sind, dass im Betriebszustand in Bereichen mit hoher Wärmeentwicklung eine im Vergleich zu anderen Bereichen höhere Strömungsgeschwindigkeit erzielbar ist.

3. Hochspannungserzeuger nach Anspruch 1,
wobei die Querschnitte so bemessen sind, dass im Betriebszustand in Bereichen mit hoher Feldtstärke und hoher Wärmeentwicklung eine im Vergleich zu anderen Bereichen höhere Strömungsgeschwindigkeit erzielbar ist.

4. Hochspannungserzeuger nach einem der Ansprüche 1, bis 3,
wobei das Isolier-Fluid (50) eine hochspannungsfeste Isolierflüssigkeit ist.

5. Hochspannungserzeuger nach einem der Ansprüche 1 bis 3,
wobei der mindestens eine Isolierkörper (30,31,..) aus einem mikroporösen, geschlossenzelligen Hartschaum hergestellt ist.

6. Hochspannungserzeuger nach einem der Ansprüche 1 bis 3,
wobei der mindestens eine Isolierkörper (30, 31,..) und das Isolier-Fluid (50) eine im wesentlichen gleiche Dielektrizitätskonstante aufweisen.

7. Hochspannungserzeuger nach einem der Ansprüche 1 bis 3,
wobei der mindestens eine Isolierkörper (30, 31,..) im wesentlichen alle Bereiche mit im Betriebszustand niedriger Wärmeentwicklung und niedriger Feldstärke ausfüllt.

8. Hochspannungserzeuger nach einem der Ansprüche 1 bis 3,
wobei der mindestens eine Isolierkörper (30, 31,..) so geformt und angeordnet ist, dass das Isolier-Fluid (50) in einem im wesentlichen geschlossenen Kreislauf strömen kann, wobei rückführende Kanäle (41, 42) entlang einer oder mehrerer Gehäuse-Außenseiten des Hochspannungserzeugers verlaufen.

9. Hochspannungserzeuger nach Anspruch 8,
wobei die rückführenden Kanäle (41, 42) einen im Vergleich zu den anderen Kanälen (40, 43, 44, 45) größeren Querschnitt aufweisen.

10. Hochspannungserzeuger nach einem der Ansprüche 1, bis 3,
wobei eine erste Fördereinrichtung (26) zur Förderung des Isolier-Fluids (50) durch die Kanäle (40, 41,..) vorgesehen ist.

11. Hochspannungserzeuger nach einem der Ansprüche 1 bis 3,
wobei ein Wärmetauscher (17) anschließbar ist, durch den das Isolier-Fluid (50) zur Abgabe von aufgenommener Wärme nach außen geführt wird.

12. Röntgensystem mit einem Röntgenstrahler und einem Hochspannungserzeuger gemäß einem der Ansprüche 1 bis 3.

13. Computertomographie-Gerät mit einem Röntgensystem,
wobei zum Betrieb des Röntgensystems ein Hochspannungserzeuger nach einem der Ansprüche 1 bis 11 vorgesehen ist.

## Claims

1. A high-voltage generator with a hybrid insulation,
**characterized in that**
the hybrid insulation comprises at least one insulating body (30 to 35) which is shaped and arranged such that a plurality of interconnected flow channels (40 to 45) for an insulating fluid (50) is created, the diameters of which are so dimensioned that in the operating state a higher flow velocity is achievable in regions with a high field strength than in other regions.

2. A high-voltage generator as claimed in claim 1,
wherein said diameters are dimensioned such that in the operating state a higher flow velocity is achievable in regions with a high heat generation than in other regions.

3. A high-voltage generator as claimed in claim 1,
wherein said diameters are dimensioned such that in the operating state a higher flow velocity is achievable in regions with a high field strength and with a high heat generation than in other regions.

4. A high-voltage generator as claimed in any one of the claims 1 to 3,
wherein the insulating fluid (50) is a high-voltage resistant insulating fluid.

5. A high-voltage generator as claimed in any one of the claims 1 to 3,
wherein the at least one insulating body (30, 31, ...) is manufactured from a micro-porous hard foam with closed cells.

6. A high-voltage generator as claimed in any one of the claims 1 to 3,
wherein the at least one insulating body (30, 31, ...) and the insulating fluid (50) have substantially the same dielectric constant.

7. A high-voltage generator as claimed in any one of the claims 1 to 3,
wherein the at least one insulating body (30, 31, ...) fills up substantially all regions which in the operating state have a low heat generation and a low field strength.

8. A high-voltage generator as claimed in any one of the claims 1 to 3,
wherein the at least one insulating body (30, 31, ...) is shaped and arranged such that the insulating fluid (50) can flow in a substantially closed circuit of which return channels (41, 42) extend along one or several external housing sides of the high-voltage generator.

9. A high-voltage generator as claimed in claim 8,
wherein said return channels (41, 42) have a larger diameter than the other channels (40, 43, 44, 45).

10. A high-voltage generator as claimed in any one of the claims 1 to 3,
wherein a first transport device (26) is provided for transporting the insulating fluid (50) through the channels.

11. A high-voltage generator as claimed in any one of the claims 1 to 3,
wherein a heat exchanger (17) can be connected by means of which the insulating fluid (50) can be conducted to the exterior for giving off its absorbed heat.

12. An X-ray system comprising an X-ray generator and a high-voltage generator as claimed in any one of the claims 1 to 3.

13. A computer tomography device with an X-ray system, wherein a high-voltage generator as claimed in any one of the claims 1 to 11 is provided for operating the X-ray system.

## Revendications

1. Générateur haute tension à isolation hybride,
**caractérisé en ce que**
l'isolation hybride présente au moins un corps isolant (30 à 35) qui est formé et disposé de façon à créer une pluralité de canaux d'écoulement (40 à 45), reliés entre eux, pour un fluide d'isolation (50), les sections transversales desdits canaux étant dimensionnées de telle sorte qu'à l'état de fonctionnement dans des zones à haute intensité de champ, une vitesse d'écoulement supérieure peut être obtenue en comparaison avec d'autres zones.

2. Générateur haute tension selon la revendication 1,
dans lequel les sections transversales sont dimensionnées de telle sorte qu'à l'état de fonctionnement dans des zones à fort dégagement de chaleur, une vitesse d'écoulement supérieure peut être obtenue en comparaison avec d'autres zones.

3. Générateur haute tension selon la revendication 1,
dans lequel les sections transversales sont dimensionnées de telle sorte qu'à l'état de fonctionnement dans des zones à haute intensité de champ ou à fort dégagement de chaleur, une vitesse d'écoulement supérieure peut être obtenue en comparaison avec d'autres zones.

4. Générateur haute tension selon l'une quelconque des revendications 1 à 3,
dans lequel le fluide d'isolation (50) est un liquide d'isolation résistant à la haute tension.

5. Générateur haute tension selon l'une quelconque des revendications 1 à 3,
dans lequel ledit au moins un corps isolant (30, 31, ...) est fabriqué à partir d'une mousse rigide microporeuse à alvéoles fermées.

6. Générateur haute tension selon l'une quelconque des revendications 1 à 3,
dans lequel ledit au moins un corps isolant (30, 31, ...) et le fluide d'isolation (50) présentent une constante diélectrique substantiellement identique.

7. Générateur haute tension selon l'une quelconque des revendications 1 à 3,
dans lequel ledit au moins un corps isolant (30, 31, ...) remplit substantiellement toutes les zones présentant à l'état de fonctionnement un faible dégagement de chaleur et une faible intensité de champ.

8. Générateur haute tension selon l'une quelconque des revendications 1 à 3,
dans lequel ledit au moins un corps isolant (30, 31, ...) est formé et disposé de telle sorte que le fluide d'isolation (50) peut s'écouler dans un circuit substantiellement fermé, dans lequel des canaux de recyclage (41, 42) s'étendent le long d'une ou de plusieurs faces extérieures de boîtier du générateur haute tension.

9. Générateur haute tension selon la revendication 8,
dans lequel les canaux de recyclage (41, 42) présentent une section transversale supérieure en comparaison avec les autres canaux (40, 43, 44, 45).

10. Générateur haute tension selon l'une quelconque des revendications 1 à 3,
dans lequel est prévu un premier équipement d'acheminement (26) pour acheminer le fluide d'isolation (50) à travers les canaux (40, 41, ...).

11. Générateur haute tension selon l'une quelconque des revendications 1 à 3,
dans lequel un échangeur thermique (17) peut être connecté à travers lequel le fluide d'isolation (50) est amené vers l'extérieur pour dégager la chaleur absorbée.

12. Système radiographique avec un dispositif émetteur de rayons X et un générateur haute tension selon l'une quelconque des revendications 1 à 3.

13. Appareil tomodensitométrique avec un système radiographique,
dans lequel pour le fonctionnement du système radiographique, un générateur haute tension selon l'une quelconque des revendications 1 à 11 est prévu.
